# EUROPEAN PATENT APPLICATION

(11) **EP 4 796 938 A1**
(43) Date of publication of application: **26.08.2026**
(21) Application number: 24883842.7
(22) Date of filing: 08.05.2024
(51) Int. Cl.: G01R 31/36, H01M 10/42

(54) **NAIL PENETRATION TEST METHOD AND DEVICE**

(30) Priority: 02.11.2023 CN 202311449327
(71) Applicant: Contemporary Amperex Technology Co., Limited, Ningde, Fujian 352100 (CN)
(72) Inventor: JIA, Fengqiu, Ningde, Fujian 352100 (CN); CHEN, Jinda, Ningde, Fujian 352100 (CN); FENG, Gaoyou, Ningde, Fujian 352100 (CN); LIAO, Guolong, Ningde, Fujian 352100 (CN); LIN, Denghua, Ningde, Fujian 352100 (CN)
(74) Representative: Gong, Jinping
(86) International application number: PCT/CN2024/091695
(87) International publication number: WO 2025/091829

(57) **Abstract**

Provided are a nail penetration test method and device, which can improve the nail penetration test performance. The method includes: controlling a penetrating nail to move towards the direction where the penetrating nail is penetrated into a battery cell; and when the voltage between the penetrating nail and a first electrode terminal of the battery cell exceeds a preset voltage, continuing controlling the penetrating nail to penetrate into a predetermined depth.

## Description

### CROSS-REFERENCE TO RELATED APPLICATIONS

The present application claims priority to Chinese Patent Application No. 202311449327.2, filed on November 2, 2023 and entitled "NAIL PENETRATION TEST METHOD AND DEVICE", which is incorporated herein by reference in its entirety.

### TECHNICAL FIELD

The present application relates to the field of batteries, and in particular, to a nail penetration test method and device.

### BACKGROUND

A nail penetration test for a battery, also referred to as an internal short circuit test, is used to evaluate safety risks of a battery cell in the event of an internal short circuit. A penetrating nail is usually penetrated into a battery cell to evaluate safety risks caused by a short circuit between an electrode sheet of the battery cell and the penetrating nail. How to improve the nail penetration test performance has become an urgent issue to be addressed.

### SUMMARY

Provided in embodiments of the present application are a nail penetration test method and device, which can improve nail penetration test performance.

According to a first aspect, provided is a nail penetration test method. The method comprises: controlling a penetrating nail to move towards the direction where the penetrating nail is penetrated into a battery cell; and continuing controlling the penetrating nail to penetrate into a predetermined depth when the voltage between the penetrating nail and a first electrode terminal of the battery cell exceeds a preset voltage.

Optionally, the battery cell comprises a first electrode sheet and a second electrode sheet that are disposed in an overlapping manner, an electrode sheet located at the outermost layer is the second electrode sheet, the first electrode terminal is an electrode terminal connected to the first electrode sheet, and the polarity of the first electrode sheet is opposite to that of the second electrode sheet.

When the penetrating nail moves towards the battery cell, the voltage between the penetrating nail and the first electrode terminal connected to the first electrode sheet is detected, and the voltage changes obviously when the penetrating nail touches or pierces the second electrode sheet located at the outermost layer. Therefore, in the embodiments of the present application, a position where the penetrating nail is located at the moment when the voltage exceeds the preset voltage is used as an initial penetration position of the penetrating nail on the battery cell, that is, a position when the penetrating nail touches or pierces the second electrode sheet located at the outermost layer, and with the initial penetration position as a starting point, the penetrating nail is controlled to continue moving to the predetermined depth inside the battery cell. In this way, without complex modifications to the battery cell, the nail penetration test can be accurately and conveniently performed by using the relationship between the physical structure and the voltage of the battery cell, and different test requirements can be met while improving the test accuracy.

In a possible implementation, the predetermined depth is determined based on the quantity of layers of electrode sheets that need to be penetrated in the nail penetration test.

In actual application, an requirement of the nail penetration test is usually characterized by the quantity of layers, that is, how many layers of electrode sheets need to be penetrated, and the quantity of layers of electrode sheets that need to be penetrated is converted into a penetration depth, so that expected test requirements can be achieved by the nail penetration test method.

In a possible implementation, the predetermined depth is determined based on the quantity of layers, the thickness of the first electrode sheet, and the thickness of the second electrode sheet.

In this embodiment, conversion may be made between the quantity of layers penetrated and a penetration depth based on the quantity of layers that are expected to be penetrated and the thickness of electrode sheets, for example, the predetermined depth is determined based on the quantity of layers, the thickness of the first electrode sheet, and the thickness of the second electrode sheet.

In a possible implementation, the predetermined depth is determined based on the quantity of layers, the thickness of the first electrode sheet, the thickness of the second electrode sheet, and the thickness of a separator and/or a preset gap value between the first electrode sheet and the second electrode sheet.

Because the thickness of the separator between the first electrode sheet and the second electrode sheet is considered, or the preset gap value is set, the accuracy of the conversion between the quantity of layers and the depth can be improved. The lamination of the first electrode sheet and the second electrode sheet has some degree of looseness, and when the penetrating nail is penetrated into the battery cell, electrode sheets are compressed in a penetration area. Some compensation can be made through the gap value, thereby improving the test accuracy.

For example, when the quantity of layers is 1, the predetermined depth is L₁, where C+S+D≤L₁≤A+C+S+D; and/or, when the quantity of layers is N, the predetermined depth is L_{N}, where (A+C+S+D)+(A+C+2S)*(N-2)+(C+2S)≤L_{N}≤(A+C+S+D)+(A+C+2S)*(N-1), and N is a positive integer greater than 1; and A is the thickness of the first electrode sheet, C is the thickness of the second electrode sheet, S is the thickness of the separator, and D is the gap value.

The preset voltage is, for example, greater than or equal to 0.5 V and less than or equal to 1.5 V, and preferably, the preset voltage is 1 V. If the preset voltage is relatively high, the test accuracy is relatively poor, and if the preset voltage is relatively low, a higher requirement is imposed on the sensitivity of the test device. Therefore, after repeated experimental demonstration, it is concluded that when the preset voltage is within the range of 0.5 V to 1.5 V, the deviation of the initial penetration position is within the thickness of one layer of electrode sheets, which can meet the test requirements of most battery cells.

In a possible implementation, the battery cell further comprises a shell, the shell is configured to accommodate the first electrode sheet and the second electrode sheet, and an avoidance hole is disposed at a position on the shell for the penetrating nail to penetrate. The avoidance hole can effectively avoid the penetrating nail, so as to facilitate the penetrating nail to penetrate into the electrode sheets.

In a possible implementation, the method further comprises: controlling the battery cell to be charged to a predetermined SOC, and left to stand for predetermined duration. The battery cell is charged to the predetermined SOC and left to stand, so that the battery cell to be tested is in a stable state, and thus the nail penetration test performance is improved.

According to a second aspect, provided is a nail penetration test device. The device comprises: a processing module, configured to control a penetrating nail to move towards the direction where the penetrating nail is penetrated into a battery cell; and a detection module, configured to detect the voltage between the penetrating nail and a first electrode terminal of the battery cell during the movement of the penetrating nail; where the processing module is further configured to continue controlling the penetrating nail to penetrate into a predetermined depth when the voltage between the penetrating nail and the first electrode terminal of the battery cell exceeds a preset voltage.

Optionally, the battery cell comprises a first electrode sheet and a second electrode sheet that are disposed in an overlapping manner, an electrode sheet located at the outermost layer is the second electrode sheet, the first electrode terminal is an electrode terminal connected to the first electrode sheet, and the polarity of the first electrode sheet is opposite to that of the second electrode sheet.

In a possible implementation, the predetermined depth is determined based on the quantity of layers of electrode sheets that need to be penetrated in the nail penetration test.

In a possible implementation, the predetermined depth is determined based on the quantity of layers, the thickness of the first electrode sheet, and the thickness of the second electrode sheet.

In a possible implementation, the predetermined depth is determined based on the quantity of layers, the thickness of the first electrode sheet, the thickness of the second electrode sheet, and the thickness of a separator and/or a preset gap value between the first electrode sheet and the second electrode sheet.

In a possible implementation, when the quantity of layers is 1, the predetermined depth is L₁, where C+S+D≤L₁≤A+C+S+D; and/or when the quantity of layers is N, the predetermined depth is L_{N}, where (A+C+S+D)+(A+C+2S)*(N-2)+(C+2S)≤L_{N}≤(A+C+S+D)+(A+C+2S)*(N-1), and N is a positive integer greater than 1; and A, C, S, and D are respectively the thickness of the first electrode sheet, the thickness of the second electrode sheet, the thickness of the separator, and the gap value.

In a possible implementation, the preset voltage is greater than or equal to 0.5 V and less than or equal to 1.5 V, for example, the preset voltage may be 1 V.

In a possible implementation, the battery cell further comprises a shell, the shell is configured to accommodate the first electrode sheet and the second electrode sheet, and an avoidance hole is disposed at a position on the shell for the penetrating nail to penetrate.

In a possible implementation, the processing module is further configured to control the battery cell to be charged to a predetermined SOC.

According to a third aspect, provided is a nail penetration test apparatus, comprising a processor, where the processor is configured to execute computer instructions stored in a memory to enable the apparatus to implement the nail penetration test method according to the first aspect or any one of the possible implementations of the first aspect.

According to a fourth aspect, provided is a computer-readable storage medium configured to store a computer program that, when executed by a computing device, enables the computing device to implement the nail penetration test method according to the first aspect or any one of the possible implementations of the first aspect.

### BRIEF DESCRIPTION OF THE DRAWINGS

In order to more clearly illustrate the technical solutions of the embodiments of the present application, the drawings required to be used in the embodiments of the present application will be briefly introduced below. Apparently, the drawings described below are only some embodiments of the present application. For persons of ordinary skill in the art, other drawings can also be obtained from the drawings without creative work.
FIG. 1 is a schematic diagram of a nail penetration test.
FIG. 2 is a schematic diagram of an initial penetration position for a nail penetration test.
FIG. 3 is a schematic flowchart of a nail penetration test method according to an embodiment of the present application.
FIG. 4 is a schematic diagram of a possible lamination of electrode sheets of a battery cell according to an embodiment of the present application.
FIG. 5 is a schematic diagram showing changes in an interface between an electrode sheet and a penetrating nail during penetration of the penetrating nail.
FIG. 6 is a schematic diagram of an equivalent circuit between a penetrating nail and a positive electrode terminal.
FIG. 7 is a schematic diagram of a possible specific implementation of the nail penetration test method shown in FIG. 3.
FIG. 8 is a schematic flowchart of a possible specific implementation of the nail penetration test method shown in FIG. 3.
FIG. 9 is a schematic block diagram of a nail penetration test device according to an embodiment of the present application.
FIG. 10 is a schematic block diagram of a nail penetration test device according to an embodiment of the present application.

### DETAILED DESCRIPTION OF PREFERRED EMBODIMENTS

The following further describes implementations of the present application in detail with reference to the accompanying drawings and embodiments. The following detailed description of the embodiments and the accompanying drawings are used to describe the principles of the present application by way of example, but are not intended to limit the scope of the present application, that is, the present application is not limited to the described embodiments.

Unless otherwise defined, all technical and scientific terms used in the present application have the same meaning as commonly understood by a person skilled in the art of the present application. In the present application, the terms used in the description of the present application are only used for describing specific embodiments and are not intended to limit the present application, and the terms "comprise", "have", and any variations thereof in the description and claims of the present application and the above description of the drawings are intended to cover a non-exclusive inclusion. The terms "first", "second", and the like in the description and claims of the present application or in the drawings are used to distinguish between different objects, and are not used to describe a specific sequence or a primary-secondary relationship. "Perpendicular" is not perpendicular in the strict sense, but is within an allowable range of error. "Parallel" is not parallel in the strict sense, but is within an allowable range of error.

An "embodiment" in the present application means that a specific feature, structure, or characteristic described with reference to the embodiment may be included in at least one embodiment of the present application. The phrase in various places in the description does not necessarily all refer to the same embodiment, or a separate or alternative embodiment mutually exclusive of other embodiments. A person skilled in the art explicitly and implicitly understands that the described embodiments in the present application may be combined with another embodiment.

In the description of the present application, it should be noted that, unless explicitly specified and defined otherwise, the terms "mount", "couple", "connect", and "attach" are to be understood in a broad sense. For example, the terms may indicate a fixed connection, a detachable connection, or an integral connection, and may indicate a direct connection or an indirect connection implemented via an intermediate medium, or internal communication between two elements. A person skilled in the art can understand specific meanings of these terms in the present application according to specific situations.

The term "and/or" in the present application is only an associative relationship for describing associated objects, indicating that three relationships may be present. For example, A and/or B may indicate three cases: the presence of only A; the presence of both A and B; and the presence of only B. In addition, the symbol "/" in the present application generally represents an "or" relationship between associated objects.

In the embodiments of the present application, the same reference numerals denote the same component, and a detailed description of the same component is omitted in different embodiments for the sake of brevity. It should be understood that the dimensions of various components, such as the thickness, length, and width, and the dimensions of an integrated device, such as the overall thickness, length, and width, in the embodiments of the present application shown in the figures are merely illustrative and should not be construed as limiting the present application.

A battery is usually a single physical module that includes one or more battery cells for providing a higher voltage and capacity. For example, the battery may include a battery module, a battery pack, or the like. Generally, the battery further includes a case for packaging one or more battery cells. The case can prevent liquids or other foreign objects from affecting the charging or discharging of the battery cells.

The battery cell includes an electrode assembly and an electrolyte. The electrode assembly includes a positive electrode sheet, a negative electrode sheet, and a separator between the positive electrode sheet and the negative electrode sheet. Working of the battery cell mainly relies on migration of metal ions between the positive electrode sheet and the negative electrode sheet. The positive electrode sheet includes a positive electrode current collector and a positive electrode active substance layer. The positive electrode active substance layer is coated on a surface of a main part of the positive electrode current collector. A part of the positive electrode current collector that is not coated with the positive electrode active substance layer protrudes from the main part of the positive electrode current collector as a positive tab. A lithium-ion battery is used as an example, for which, the positive electrode current collector may be made of aluminum, and the positive electrode active substance may be lithium cobalt oxide, lithium iron phosphate, ternary lithium, lithium manganate oxide, or the like. The negative electrode sheet includes a negative electrode current collector and a negative electrode active substance layer. The negative electrode active substance layer is coated on a surface of a main part of the negative electrode current collector. A part of the negative electrode current collector that is not coated with the negative electrode active substance layer protrudes from the main part of the negative electrode current collector as a negative tab. The negative electrode current collector may be made of copper, and the negative electrode active substance may be carbon, silicon, or the like. To reduce the probability of fusing when a high current passes through, a plurality of positive tabs may be provided and stacked together, and a plurality of negative tabs may be provided and stacked together.

To simulate an internal short circuit scenario caused by contamination of a battery by conductive particles and the like, a penetrating nail with a diameter of about 1 mm may be penetrated into electrode sheets of a battery cell to induce an internal short circuit of the battery cell, so as to evaluate safety risks of the battery cell in the event of the internal short circuit. This process is usually referred to as a nail penetration test, a shallow penetration test, or an internal short circuit test for a battery. It may be understood that a penetration position of a penetrating nail on an electrode sheet corresponds to a main part of a current collector coated with an active substance layer on the electrode sheet.

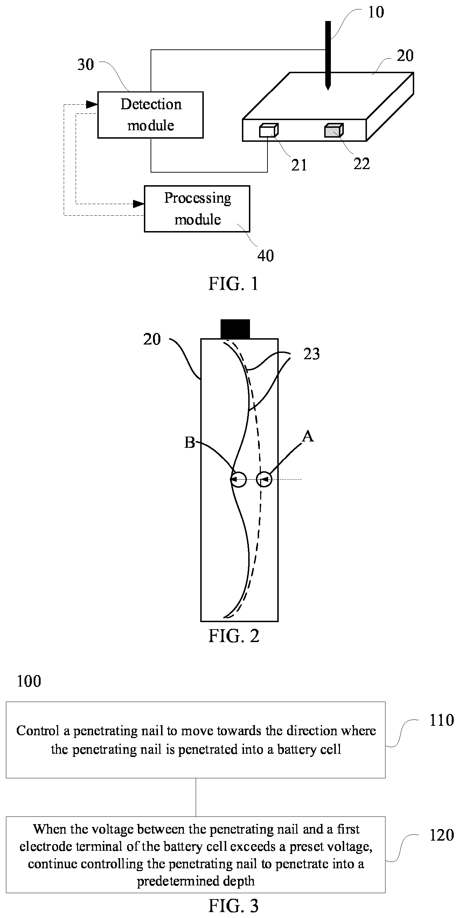

For example, as shown in FIG. 1, a penetrating nail 10 is connected to a first electrode terminal 21 of a battery cell 20, and the polarity of the first electrode terminal 21 is opposite to that of a second electrode terminal 22, for example, the first electrode terminal 21 is a negative electrode terminal and the second electrode terminal 22 is a positive electrode terminal, or the first electrode terminal 21 is a positive electrode terminal and the second electrode terminal 22 is a negative electrode terminal. The battery cell 20 includes a positive electrode sheet and a negative electrode sheet that are disposed in an overlapping manner, if the positive electrode sheet is at the outermost layer, the first electrode terminal 21 connected to the penetrating nail 10 is a negative electrode terminal; and if the negative electrode sheet is at the outermost layer, the first electrode terminal 21 connected to the penetrating nail 10 is a positive electrode terminal.

For example, if the negative electrode sheet is at the outermost layer and the first electrode terminal 21 is the positive electrode terminal, the penetrating nail 10 is connected to the first electrode terminal 21. During the movement of the penetrating nail 10 towards the battery cell 20, before the penetrating nail 10 moves to touch or pierce the negative electrode sheet at the outermost layer, a loop is not formed among the negative electrode sheet at the outermost layer, the penetrating nail 10, a detection module 30, and the first electrode terminal 21. At the moment when the penetrating nail 10 moves to touch or pierce the negative electrode sheet at the outermost layer, a loop is formed among the negative electrode sheet at the outermost layer, the penetrating nail 10, the detection module 30, and the first electrode terminal 21, and the detection module 30 can detect the voltage between the positive electrode sheet and the negative electrode sheet. As the penetrating nail 10 continues to penetrate into the battery cell 20, an internal short circuit is formed between the positive electrode sheet and the negative electrode sheet via the penetrating nail 10, and the detection module 30 may detect a drop in the voltage between the penetrating nail 10 and the first electrode terminal 21. At this time, the penetrating nail 10 stops moving, and it is considered that the penetrating nail 10 is penetrated into the first layer of negative electrode sheet and positive electrode sheet of the battery cell 20.

Generally, an requirement of the nail penetration test is that the penetrating nail 10 is penetrated into a layer of positive electrode sheet and negative electrode sheet within the battery cell 20. A processing module 40 may determine, based on changes in the voltage between the penetrating nail 10 and the first electrode terminal 21 detected by the detection module 30, whether the penetrating nail 10 is penetrated into a layer of positive electrode sheet and negative electrode sheet of the battery cell 20.

However, in other scenarios, it is also expected that the test penetrating nail 10 is penetrated into multiple layers of positive electrode sheets and negative electrode sheets within the battery cell 20. Because the positive electrode sheet and the negative electrode sheet are stacked, there is some degree of looseness. For example, as shown in FIG. 2, when a penetrating nail 10 is penetrated into a battery cell 20, an electrode sheet 23 is compressed in an area near a penetration position. Therefore, there is a deviation between a theoretical initial position A of the penetrating nail on the battery cell 20 and an actual initial penetration position B of the penetrating nail 10 on the battery cell 20. Because the initial position B of the penetrating nail 10 cannot be accurately determined, the voltage drop caused by a short circuit between multiple layers of positive electrode sheets and negative electrode sheets via the penetrating nail 10 cannot be identified. As a result, more test requirements cannot be met.

Therefore, the present application proposes a nail penetration test solution designed to determine an initial penetration position of a penetrating nail on a battery cell based on the relationship between the physical structure and the voltage of the battery cell, so as to control a penetration depth of the penetrating nail in the battery cell or the quantity of layers based on the initial penetration position, thereby meeting different test requirements.

As an example, FIG. 3 shows a schematic flowchart of a nail penetration test method according to an embodiment of the present application. A battery cell to be tested may, for example, include a secondary battery such as a sodium ion battery or a lithium ion battery, and a structure thereof includes a first electrode sheet and a second electrode sheet that are disposed in an overlapping manner, an electrode sheet located at the outermost layer is the second electrode sheet, and the polarity of the first electrode sheet is opposite to the second electrode sheet. A method 100 may be applied to nail penetration tests for various structures and types of battery cells 20, and the battery cells 20 may be of a wound structure or a laminated structure, or may be cylindrical battery cells or pouch battery cells. These battery cells may be tested by using a nail penetration test method 100 provided in an embodiment of the present application.

As shown in FIG. 3, the method 100 includes some or all of the following steps.

In step 110, a penetrating nail 10 is controlled to move towards the direction where the penetrating nail is penetrated into a battery cell 20.

In step 120, when the voltage between the penetrating nail 10 and a first electrode terminal of the battery cell 20 exceeds a preset voltage, the penetrating nail 10 continues to be controlled to penetrate into a predetermined depth.

Optionally, the battery cell 20 includes a first electrode sheet and a second electrode sheet that are disposed in an overlapping manner, an electrode sheet located at the outermost layer is the second electrode sheet, the first electrode terminal is an electrode terminal connected to the first electrode sheet on the battery cell 20, and the polarity of the first electrode sheet is opposite to that of the second electrode sheet.

A positive electrode sheet of the battery cell 20 is connected to a positive electrode terminal, and a negative electrode sheet is connected to a negative electrode terminal. When an electrode sheet at the outermost layer of the battery cell 20 is configured as a negative electrode sheet, the penetrating nail 10 may be connected to the positive electrode terminal of the battery cell 20 to detect the voltage between the penetrating nail 10 and the positive electrode terminal during the movement of the penetrating nail 10 towards the battery cell 20, and the voltage between the penetrating nail 10 and the positive electrode terminal is the voltage between the penetrating nail 10 and a main positive terminal of the battery cell 20. When an electrode sheet at the outermost layer of the battery cell 20 is configured as a positive electrode sheet, the penetrating nail 10 may be connected to the negative electrode terminal of the battery cell 20 to detect the voltage between the penetrating nail 10 and the negative electrode terminal during the movement of the penetrating nail 10 towards the battery cell 20, and the voltage between the penetrating nail 10 and the negative electrode terminal is the voltage between the penetrating nail 10 and a main negative terminal of the battery cell 20.

The "when the voltage between the penetrating nail 10 and a first electrode terminal of the battery cell 20 exceeds a preset voltage" described in step 120 may, for example, refer to the moment when the voltage between the penetrating nail 10 and the first electrode terminal of the battery cell 20 exceeds the preset voltage. Specifically, during the movement of the penetrating nail 10 towards the battery cell 20, the voltage between the penetrating nail 10 and the first electrode terminal of the battery cell 20 needs to be detected, and a position where the penetrating nail 10 is located at the moment when the voltage between the penetrating nail 10 and the first electrode terminal exceeds the preset voltage is used as an initial penetration position of the penetrating nail 10 on the battery cell 20, so that the penetrating nail 10 is penetrated into the predetermined depth in the battery cell 20 based on the initial penetration position. The predetermined depth is a distance by which the penetrating nail 10 moves inside the battery cell 20, that is, a penetration depth of the penetrating nail 10 into the battery cell 20.

The voltage between the penetrating nail 10 and the first electrode terminal of the battery cell 20 may be detected by using a detection module 30 connected between the penetrating nail 10 and the first electrode terminal of the battery cell 20, and the detection module 30 may, for example, include a voltage detection device such as a voltmeter or a voltage acquisition card.

The initial penetration position is a position where the penetrating nail 10 is located when the penetrating nail 10 starts to penetrate into the battery cell 20. At this time, the penetrating nail 10 may touch or have slightly pierced the second electrode sheet at the outermost layer. In other words, the initial penetration position may be regarded as a position where the penetrating nail 10 is located when the penetrating nail 10 touches or pierces the second electrode sheet at the outermost layer, for example, the initial penetration position may be a position where a nail tip of the penetrating nail 10 is located, a position where a nail tail end of the penetrating nail 10 is located, or a position where another part of the penetrating nail 10 is located. Then, the penetrating nail 10 may be controlled to continue moving with the initial penetration position as a starting point until the penetrating nail is penetrated into the battery cell 20 to the predetermined depth. Here, the step of controlling the penetrating nail 10 includes: directly or indirectly controlling the penetrating nail 10, that is, directly controlling the penetrating nail 10 to penetrate into the battery cell 20 to the predetermined depth from the initial penetration position, or controlling a clamping device for clamping the penetrating nail 10 to enable the penetrating nail 10 to penetrate into the battery cell 20 to the predetermined depth from the initial penetration position.

During the movement of the penetrating nail 10 towards the battery cell 20, the voltage between the penetrating nail 10 and the first electrode terminal is detected. When the penetrating nail 10 touches or pierces the second electrode sheet at the outermost layer, a loop is formed among the second electrode sheet at the outermost layer, the penetrating nail 10, the detection module 30, and the first electrode terminal 21, and the voltage between the penetrating nail 10 and the first electrode terminal 21 changes. Therefore, in this embodiment of the present application, a position to which the penetrating nail 10 moves at the moment when the voltage between the penetrating nail 10 and the first electrode terminal exceeds a preset voltage is determined as an initial penetration position. With the initial penetration position as a starting point, the penetrating nail 10 is controlled to continue moving to the predetermined depth inside the battery cell 20. In this way, without complex modifications to the battery cell 20, an initial penetration position where the penetrating nail starts to penetrate into the battery cell 20 can be determined by using the relationship between the physical structure and the voltage of the battery cell 20, so as to perform a nail penetration test on a predetermined quantity of layers or a predetermined depth in the battery cell 20, thereby meeting the test requirements for different quantities of layers penetrated and penetration depths.

The direction where the penetrating nail is penetrated into the battery cell 20 in step 110 may be, for example, a direction perpendicular to or approximately perpendicular to electrode sheets of the battery cell 20. In other words, the penetrating nail 10 may be penetrated into the electrode sheets of the battery cell 20 in a vertical or approximately vertical direction, that is, when the penetrating nail 10 moves towards the battery cell 20, the moving direction of the penetrating nail 10 is perpendicular to or approximately perpendicular to surfaces of the electrode sheets.

An requirement of the nail penetration test may be characterized by the quantity of layers, and the requirement of the nail penetration test may be that the penetrating nail 10 is expected to penetrate into multiple layers of positive electrode sheets and negative electrode sheets in the battery cell 20. Optionally, the predetermined depth in step 120 is associated with the quantity of layers of electrode sheets that need to be penetrated in the nail penetration test. For example, different depths correspond to different quantities of layers. When the quantity of layers of electrode sheets that are expected to be penetrated is N1, the predetermined depth is M1; when the quantity of layers of electrode sheets that are expected to be penetrated is N2, the predetermined depth is M2; when the quantity of layers that are expected to be penetrated is N3, the predetermined depth is M3; and so on.

Therefore, the quantity of layers of electrode sheets that are expected to be penetrated needs to be converted into a penetration depth, so as to control the moving distance of the penetrating nail 10 based on the initial penetration position, thereby enabling the penetrating nail 10 to penetrate into the battery cell 20 to the predetermined depth. In this way, the expected test requirements can be met by the nail penetration test method.

Certainly, if an requirement of the nail penetration test is characterized by a depth, for example, the requirement of the nail penetration test may be that the penetrating nail 10 is expected to penetrate into the battery cell 20 to a predetermined depth, then after an initial penetration position is determined, the penetrating nail 10 is controlled to continue moving by a corresponding distance based on the initial penetration position. For example, if the predetermined depth is 1.5 mm, the penetrating nail 10 is controlled to continue moving by 1.5 mm with the initial penetration position as a starting point. For another example, if the predetermined depth is 2 mm, the penetrating nail 10 is controlled to continue moving by 2 mm with the initial penetration position as a starting point.

Therefore, in some embodiments, the method 100 further includes: determining the predetermined depth based on the quantity of layers of electrode sheets that need to be penetrated in the nail penetration test. In other words, the predetermined depth may be determined based on the quantity of layers of electrode sheets that need to be penetrated in the nail penetration test. It may be understood that the quantity of layers of electrode sheets described in the embodiments of the present application is the quantity of layers of a pair of electrode sheets formed by a first electrode sheet and a second electrode sheet, that is, each layer of electrode sheets includes one layer of the first electrode sheet and one layer of the second electrode sheet. When a separator is considered, each layer of electrode sheets may include one layer of the first electrode sheet, one layer of the second electrode sheet, and one layer of the separator or two layers of the separator.

The term "penetration" as described in the embodiments of the present application may be understood in a broad sense. The penetration of the penetrating nail 10 into an electrode sheet includes the penetrating nail 10 touching and/or piercing the electrode sheet.

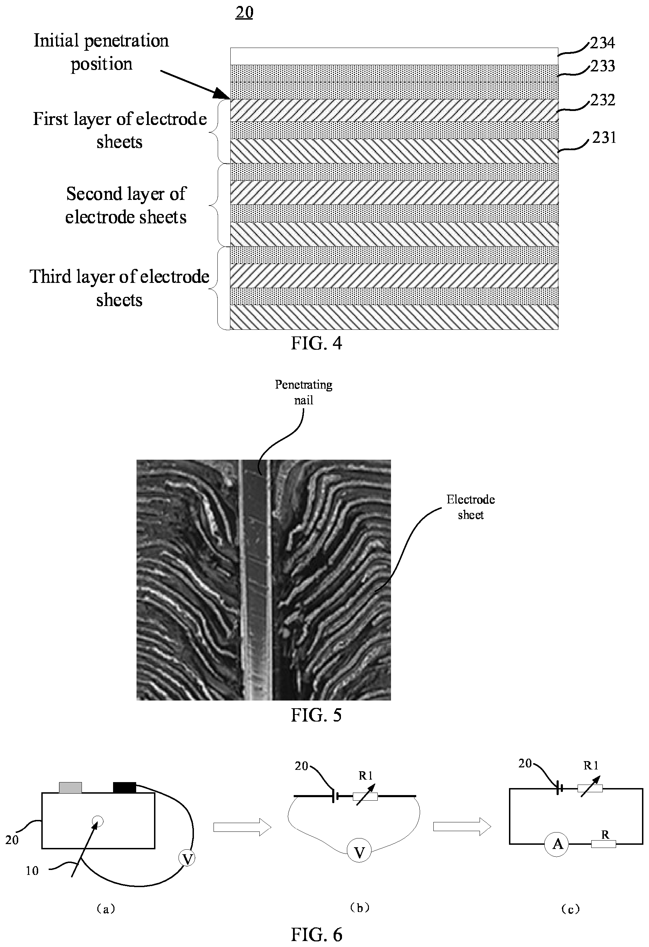

FIG. 4 is a schematic diagram of a possible lamination of electrode sheets of a battery cell 20. As shown in FIG. 4, a first electrode sheet 231 and a second electrode sheet 232 are disposed in an overlapping manner, an electrode sheet located at the outermost layer is the second electrode sheet 232, a separator 233 is disposed between the first electrode sheet 231 and the second electrode sheet 232, and an insulating layer 234 is further disposed at the outermost layer. During movement of a penetrating nail 10 towards the battery cell 20, the penetrating nail 10 is first penetrated into the insulating layer 234 at the outermost layer and two layers of separator 233, and compresses electrode sheets to some extent in this process. Then, the penetrating nail touches or pierces the second electrode sheet 232 at the outermost layer, and in this process, a change in the voltage between a first electrode terminal of the battery cell and the penetrating nail 10 is detected, so that an initial penetration position is determined based on the change in the voltage.

Based on the initial penetration position, the penetrating nail 10 continues moving and is sequentially penetrated into a first layer of electrode sheets, a second layer of electrode sheets, a third layer of electrode sheets, and the like. As an example, FIG. 4 shows only three layers of electrode sheets, where the first layer of electrode sheets includes one layer of the first electrode sheet 231, one layer of the second electrode sheet 232, and a separator 233 therebetween. Starting from the second layer of electrode sheets, each layer of electrode sheets includes one layer of the first electrode sheet 231, one layer of the second electrode sheet 232, and two layers of the separator 233, for example, the second layer of electrode sheets and the third layer of electrode sheets shown in FIG. 4.

It should be noted that the definition of the quantity of layers of electrode sheets in the embodiments of the present application is only an example, and appropriate adjustments may be made in actual application. For example, the first electrode sheet 231 is used as a layer of electrode sheet alone, and the second electrode sheet 232 is used as a layer of electrode sheet alone. In this case, as shown in FIG. 4, the first layer of electrode sheet includes one layer of the second electrode sheet 232, the second layer of electrode sheet includes one layer of the first electrode sheet 231 and one layer of the separator 233, the third layer of electrode sheet includes one layer of the second electrode sheet 232 and one layer of the separator, and so on.

Optionally, the predetermined depth in step 120 is associated with the thickness of the first electrode sheet and the thickness of the second electrode sheet of the battery cell. Further, the predetermined depth may also be associated with the thickness of the first electrode sheet, the thickness of the second electrode sheet, and the thickness of the separator between the first electrode sheet and the second electrode sheet of the battery cell and/or a preset gap value.

In some embodiments, the predetermined depth may be determined based on the quantity of layers of electrode sheets that need to be penetrated in the nail penetration test, the thickness of the first electrode sheet 231, and the thickness of the second electrode sheet 232.

Further, in other embodiments, the predetermined depth may be determined based on the quantity of layers of electrode sheets that need to be penetrated in the nail penetration test, the thickness of the first electrode sheet 231, the thickness of the second electrode sheet 232, and the thickness of the separator 233 between the first electrode sheet 231 and the second electrode sheet 232 and/or a preset gap value D.

In other words, conversion is made between the quantity of layers penetrated and a penetration depth based on the quantity of layers that are expected to be penetrated and the thickness of electrode sheets, for example, the predetermined depth that is expected is determined based on the quantity of layers of electrode sheets that are expected to be penetrated, the thickness of the first electrode sheet 231, the thickness of the second electrode sheet 232, and the thickness of the separator 233 between the first electrode sheet 231 and the second electrode sheet 232 and/or the preset gap value D.

Optionally, when the quantity of layers of electrode sheets that need to be penetrated is 1, that is, one layer of the first electrode sheet 231 and one layer of the second electrode sheet 232 are expected to be penetrated, the predetermined depth is L₁, where C+S+D≤L₁≤A+C+S+D. A is the thickness of the first electrode sheet 231, C is the thickness of the second electrode sheet 232, S is the thickness of the separator 233, and D is the gap value.

For example, the above depth range may be mapped based on data such as the first electrode sheet 231, the second electrode sheet 232, the separator 233 or the quantity of layers that need to be penetrated of the battery cell 20, and any value within the depth range is selected as the predetermined depth, for example, an intermediate value within the depth range is selected.

Optionally, when the quantity of layers of electrode sheets that need to be penetrated is N, that is, N layers of the first electrode sheet 231 and N layers of the second electrode sheet 232 are expected to be penetrated, the predetermined depth is L_{N}, where (A+C+S+D)+(A+C+2S)*(N-2)+(C+2S)≤L_{N}≤(A+C+S+D)+(A+C+2S)*(N-1), and N is a positive integer greater than 1.

Because the first electrode sheet 231 and the second electrode sheet 232 of the battery cell 20 are compacted to different degrees after being overlapped, a gap exists between the electrode sheets, and the gap value D may be determined, for example, based on a manufacturing process. When the penetrating nail 10 is penetrated into the battery cell 20, electrode sheets are compressed in a penetration area. With the gap value D, some compensation can be made, thereby improving the test accuracy.

For example, if one layer of electrode sheets needs to be penetrated, the penetration depth L₁ of the penetrating nail 10 in the battery cell 20 may be within the range of C+S+D to A+C+S+D; if two layers of electrode sheets need to be penetrated, the penetration depth L₂ of the penetrating nail 10 into the battery cell 20 may be within the range of (A+C+S+D) + (C+2S) to (A+C+S+D) + (A+C+2S);...; and if N layers of electrode sheets need to be penetrated, the penetration depth L_{N} of the penetrating nail 10 in the battery cell 20 may be within the range of (A+C+S+D) + (A+C+2S) * (N-2) + (C+2S) to (A+C+S+D) + (A+C+2S) * (N-1). In this way, a short circuit may occur between the first electrode sheet 231 and the second electrode sheet 232 in each layer of electrode sheets, thereby achieving an internal short circuit at a corresponding position in the battery cell 20.

For example, one layer of electrode sheets, namely the first layer of electrode sheets, need to be penetrated, as shown in FIG. 4, the first layer of electrode sheets includes the second electrode sheet 232, the separator 233, and the first electrode sheet 231 from top to bottom. When the penetration depth of the penetrating nail 10 in the battery cell 20 is L₁=C+S+D, the penetrating nail 10 is sequentially penetrated into the second electrode sheet 232 at the outermost layer, and the separator 233 on the lower surface of the second electrode sheet 232 at the outermost layer during the movement, and then a nail tip contacts the upper surface of the first electrode sheet 231. When the penetration depth of the penetrating nail 10 in the battery cell 20 is L₁=A+C+S+D, the penetrating nail 10 is sequentially penetrated into the second electrode sheet 232 at the outermost layer, the separator 233 on the lower surface of the second electrode sheet 232 at the outermost layer, and the first electrode sheet 231 during the movement, and then a nail tip reaches the lower surface of the first electrode sheet 231. Therefore, when C+S+D≤L₁≤A+C+S+D, the nail tip may be located at any position in the first electrode sheet 231. In this case, the second electrode sheet 232 and the first electrode sheet 231 are short-circuited by the penetrating nail 10, which causes an internal short circuit in the battery cell 20, thereby achieving the purpose of the nail penetration test.

It may be understood that in actual application, due to factors such as the sensitivity of a voltage detection device or the moving rate of the penetrating nail 10, there may be a deviation in the initial penetration position determined based on the above method. For example, when the initial penetration position is determined based on the voltage between the positive electrode terminal and the penetrating nail 10, the penetrating nail 10 may have already penetrated into the second electrode sheet 232 at the outermost layer to a depth, so that after the penetrating nail 10 continues to penetrate to the predetermined depth, an actual penetration depth of the penetrating nail in the battery cell 10 is slightly greater than the predetermined depth. For example, if one layer of electrode sheets needs to be penetrated, the maximum value L₁ₘₐₓ of the penetration depth of the penetrating nail 10 in the battery cell 20 may be slightly greater than A+C+S+D; if two layers of electrode sheets need to be penetrated, the maximum value L₂ₘₐx of the penetration depth of the penetrating nail 10 in the battery cell 20 may be slightly greater than (A+C+S+D)+(A+C+2S);...; and if N layers of electrode sheets need to be penetrated, the maximum value L_{Nmax} of the penetration depth of the penetrating nail 10 in the battery cell 20 may be slightly greater than (A+C+S+D)+(A+C+2S)*(N-1).

Certainly, such a deviation may be accepted as long as the deviation of the predetermined depth is within an acceptable range. Generally, the deviation of the predetermined depth does not exceed a preset value P. For example, when the quantity of layers of electrode sheets that need to be penetrated is 1, the maximum value L₁ₘₐₓ of the predetermined depth satisfies A+C+S+D≤L₁ₘₐₓ≤A+C+S+D+P; and when the quantity of layers of electrode sheets that need to be penetrated is N, the maximum value L₂ₘₐₓ of the predetermined depth satisfies (A+C+S+D)+(A+C+2S)*(N-1)≤Lₙₘₐₓ≤(A+C+S+D)+(A+C+2S)*(N-1)+P. P is a preset value, for example, P may be equal to the thickness of the second electrode sheet 232, or the sum of the thickness of the second electrode sheet 232 and the thickness of the separator 233.

As an example, generally, for a battery cell 10 of an NCM chemical system, the thicknesses of the positive electrode sheet, the negative electrode sheet, and the separator (including CCS+PCS) are respectively 0.116 mm, 0.173 mm, and 0.011 mm; for a battery cell 20 of an LFP chemical system, the thicknesses of the positive electrode sheet, the negative electrode sheet, and the separator (including CCS+PCS) are respectively 0.144 mm, 0.172 mm, and 0.0118 mm; and for a sodium-ion battery cell 20, the thicknesses of the positive electrode sheet, the negative electrode sheet, and the separator (including CCS+PCS) are respectively 0.204 mm, 0.205 mm, and 0.0120 mm.

The thickness of the positive electrode sheet or the negative electrode sheet of the battery cell 20 may be, for example, between 0.1 mm and 0.5 mm, and further, between 0.1 mm and 0.25 mm, where the thickness of the negative electrode sheet may be greater than that of the positive electrode sheet. The thickness of the separator is usually much smaller than the thicknesses of the positive electrode sheet and the negative electrode sheet. Therefore, in the embodiments of the present application, the separator may also be ignored when conversion is made between the quantity of layers and the depth.

Optionally, the battery cell 20 further includes a shell (not shown in FIG. 4), the shell is configured to accommodate a laminated structure formed by the first electrode sheet 231 and the second electrode sheet 232 shown in FIG. 4, and an avoidance hole is disposed at a position on the shell for the penetrating nail 10 to penetrate. The avoidance hole can effectively avoid the penetrating nail 10, so as to facilitate the penetrating nail 10 to penetrate into the electrode sheets. The size of the avoidance hole may be slightly larger than the diameter of the penetrating nail 10, for example, the diameter of the avoidance hole may be set to about 10 mm, for example, greater than or equal to 10 mm.

In some embodiments, before the above nail penetration test is performed, the battery cell 20 may be charged to a predetermined state of charge (SOC), and left to stand for predetermined duration. For example, based on a predetermined current, the battery cell 20 is charged to a cut-off voltage of the battery cell 20, and left to stand for predetermined duration. The battery cell 20 is charged to a fully charged state and left to stand, so that the battery cell 20 to be tested is in a stable state, and thus the nail penetration test performance can be improved.

Theoretically, the preset voltage may be any voltage value between 0 V and an open-circuit voltage of the battery cell 20. In other words, the initial penetration position may be confirmed as long as the voltage is detected to change from 0. When the sensitivity of the voltage detection device is sufficient, the preset voltage should be as low as possible. However, in actual application, optionally, the preset voltage may be set to be greater than or equal to 0.5 V and less than or equal to 1.5 V, greater than or equal to 0.6 V and less than or equal to 1.4 V, greater than or equal to 0.7 V and less than or equal to 1.3 V, greater than or equal to 0.8 V and less than or equal to 1.2 V, or greater than or equal to 0.9 V and less than or equal to 1.1 V.

In this embodiment of the present application, the preset voltage is, for example, 1 V. During the movement of the penetrating nail 10 towards the battery cell 20, if the voltage between the penetrating nail 10 and the first electrode terminal suddenly changes to exceed the preset voltage, it is considered that the penetrating nail 10 touches or pierces the second electrode sheet 232 at the outermost layer, and the position where the penetrating nail 10 is located at this time may be used as the initial penetration position. Based on the initial penetration position, the penetrating nail 10 is controlled to continue moving for a distance before stopping, and the distance by which the penetrating nail 10 continues moving from the initial penetration position is equal to the above predetermined depth.

If the preset voltage is relatively high, the test accuracy is relatively poor, and the initial penetration position cannot be positioned in time when the penetrating nail 10 touches or pierces the second electrode sheet 232 at the outermost layer. If the preset voltage is relatively low, a higher requirement is imposed on the sensitivity of the test device, and test results are easily affected by interference from other factors in the test. Therefore, after repeated experimental demonstration, it is concluded that when the preset voltage is within the above voltage range, the deviation of the initial penetration position is within one layer, which can meet the test requirements of most battery cells. Preferably, the preset voltage may be set to 1 V. Certainly, when the sensitivity of the test device is high enough, the preset voltage may also be set to be lower, such as 0.5 V, 0.6 V, 0.7 V, or 0.8 V.

FIG. 5 shows changes in an interface between an electrode sheet and a penetrating nail 10 during penetration of the penetrating nail 10 into a battery cell 20. Because the battery cell 20 is formed by overlapping a positive electrode sheet 1, a separator, and a negative electrode sheet, it is assumed that an electrode sheet at the outermost layer is the negative electrode sheet, a voltage line is arranged between the penetrating nail 10 and a positive electrode terminal of the battery cell 20, and the voltage V between the penetrating nail 10 and the positive electrode terminal is detected. During the movement of the penetrating nail 10 towards the battery cell 20, when the penetrating nail 10 touches or pierces the negative electrode sheet at the outermost layer, the voltage V between the penetrating nail 10 and the positive electrode terminal suddenly rises to V1. Theoretically, V1 is approximately equal to the voltage between the positive electrode terminal and a negative electrode terminal of the battery cell 20. However, during actual tests, there are differences in the interface of the penetrating nail 10. As shown in FIG. 5, different contact modes between the penetrating nail 10 and the negative electrode sheet cause changes in corresponding contact resistance. After actual detection, it is found that the resistance can fluctuate up to a MΩ level, and after voltage division, the resistance causes fluctuations in the voltage V between the penetrating nail 10 and the positive electrode terminal.

For example, FIG. 6 is a schematic diagram of an equivalent circuit between a penetrating nail 10 and a positive electrode terminal, (a) of FIG. 6 is a schematic diagram of a connection between the penetrating nail 10 and the positive electrode terminal of a battery cell 20 in a nail penetration test, and (b) of FIG. 6 is an equivalent circuit of (a). As shown in (b) of FIG. 6, the contact resistance between the penetrating nail 10 and a negative electrode sheet is R1. R1 causes voltage division, resulting in fluctuations in the voltage V between the penetrating nail 10 and the positive electrode terminal. (c) of FIG. 6 is an equivalent circuit diagram after the voltage V between the penetrating nail 10 and the positive electrode terminal shown in (b) of FIG. 6 is converted into a current and a corresponding resistance R2.

Test results shown in Table 1 may be obtained from actual tests performed on different types of battery cells by using the above method for determining the initial penetration position. The suddenly changed voltage in Table 1 is the voltage V between the penetrating nail 10 and the positive electrode terminal when the penetrating nail 10 touches or pierces the negative electrode sheet at the outermost layer during the movement. In Table 1, battery cells 20 with capacities of 151 Ah, 160 Ah, 138 Ah, and 173 Ah as well as battery cells 20 with chemical systems made of a lithium iron phosphate (LiFePO₄, LFP) material and a nickel-cobalt-manganese (Ni-Co-Mn, NCM) ternary material are tested by using the above nail penetration test method 100.

Using a preset voltage of 1 V as an example, a position where the penetrating nail 10 is located when the voltage V between the penetrating nail 10 and the positive electrode terminal exceeds 1 V during the movement of the penetrating nail 10 may be considered as the initial penetration position of the penetrating nail 10, that is, the moment when the penetrating nail 10 touches or pierces the negative electrode sheet. At this time, the battery cell 20 may be disassembled to determine whether the initial penetration position determined based on the suddenly changed voltage is accurate based on the state of each layer of electrode sheets after disassembly. If the initial penetration position is accurate, the quantity of layers penetrated by the penetrating nail 10 after disassembly should be less than one layer, that is, the quantity of layers penetrated is equal to 0 layer or 0.5 layer. Here, one layer of the positive electrode sheet and one layer of the negative electrode sheet are collectively referred to as one layer of electrode sheets. Therefore, the 0.5 layer in Table 1 only includes one layer of the negative electrode sheet, that is, only the negative electrode sheet is pierced by the penetrating nail 10, and the 0 layer in Table 1 indicates that the penetrating nail 10 touches the negative electrode sheet but does not pierce the negative electrode sheet. It may be understood that regardless of whether the penetrating nail 10 touches the negative electrode sheet or pierces the negative electrode sheet, the voltage V between the penetrating nail 10 and the positive electrode terminal suddenly changes, and the suddenly changed voltage is greater than or equal to the preset voltage of 1 V.

It may be learned from Table 1 that based on the nail penetration test method 100 in this embodiment of the present application, for different types of battery cells 20, the deviation of the initial penetration position is less than one layer when the preset voltage is set to 1 V, so that the initial penetration position can be accurately determined, thereby meeting different test requirements of the nail penetration test.

**Table 1**

| No. | Capacity/Ah | Chemical system | Penetration rate mm/s | Suddenly changed voltage/V | Quantity of layers disassembled |
|---|---|---|---|---|---|
| 1 | 151 | NCM | 0.01 | 1.80469 | 0.5 |
| 2 | | | 0.01 | 1.00017 | 0.5 |
| 3 | | | 0.01 | 1.15199 | 0.5 |
| 4 | | | 0.1 | 1.52124 | 0.5 |
| 5 | | | 0.1 | 1.15601 | 0 |
| 6 | | | 0.1 | 1.69299 | 0.5 |
| 7 | 160 | NCM | 0.1 | 3.89252 | 0 |
| 8 | | | 0.1 | 3.62795 | 0 |
| 9 | | | 0.1 | 1.60813 | 0 |
| 10 | 138 | NCM | 0.1 | 3.09797 | 0.5 |
| 11 | | | 0.1 | 4.19577 | 0.5 |
| 12 | | | 0.1 | 2.79104 | 0 |
| 13 | 173 | LFP | 0.1 | 1.07593 | 0 |
| 14 | | | 0.1 | 1.83914 | 0.5 |

It should be understood that in the above examples, the electrode sheet at the outermost layer of the battery cell 20 is the negative electrode sheet, and the penetrating nail is connected to the positive electrode terminal. When the electrode sheet at the outermost layer of the battery cell 20 is the positive electrode sheet, the penetrating nail needs to be connected to the negative electrode terminal. A specific test process is similar, and details are not described herein again for brevity.

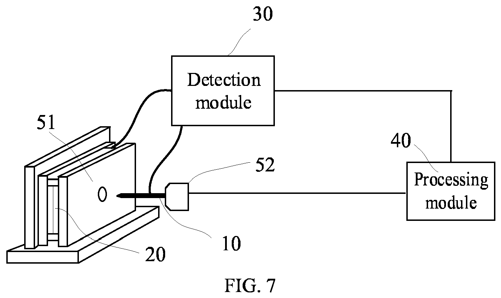

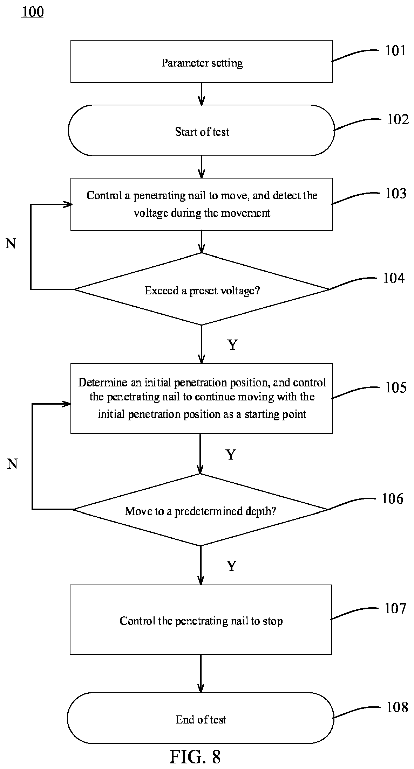

FIG. 7 and FIG. 8 show a possible specific implementation of a nail penetration test method 100.

It may be understood that before the nail penetration test is performed, operations such as preprocessing and adjustment of SOC may be performed on a battery cell 20 to be tested.

The preprocessing includes operations such as taking pictures of the battery cell to be tested, testing the voltage, internal resistance and weight, and recording the state of the battery cell 20 before the test; and the adjustment of SOC may, for example, include charging the battery cell 20 to the cut-off voltage of the battery cell 20 based on a current of not less than 1/3C, and leaving the battery cell 20 to stand for 1 h to 2 h, so that the battery cell 20 is in a stable state. When the battery cell 20 is a hard-shell battery cell, additional processing such as shell removal is needed to remove a shell of a part to be tested, that is, shell removal means that an avoidance hole with a diameter of, for example, at least 20 mm or at least 10 mm, is reserved at a position on the shell of the battery cell 20 for the penetrating nail to penetrate.

As an example, as shown in FIG. 8, the battery cell 20 may be secured by using a clamp 51, and an avoidance hole with a diameter of, for example, at least 20 mm or at least 10 mm, is reserved at a position on the clamp 51 for the penetrating nail to penetrate.

Optionally, a high-temperature resistant steel nail with an insulating stopper 52 may be selected as the penetrating nail 10, the diameter of the penetrating nail 10 may be, for example, 1 mm, the conical angle of a nail tip may be, for example, 20° to 30°, and the surface of the penetrating nail 10 should be smooth and free of rust, oxide layers, and oil stains. The moving rate of the penetrating nail 10 is, for example, less than or equal to 0.1 mm/s, and the penetrating nail 10 is penetrated in a direction perpendicular to an electrode plate of the battery cell 20, with a penetration position close to the geometric center of a penetrated surface.

The values of parameters such as the diameter and the moving rate of the penetrating nail 10 may be selected based on actual conditions, and the present application is not limited thereto.

A positive electrode terminal of the battery cell 20 and the penetrating nail 10 are connected by using a voltage line, and parameters are set. In the example shown in FIG. 7 and FIG. 8, a second electrode sheet 232 at the outermost layer is a negative electrode sheet. Before the test, the battery cell to be tested may be charged to a predetermined SOC based on the charging method in relevant standards. For example, to make test conditions more stringent, the battery cell 20 is usually charged to 100% SOC.

As shown in FIG. 8, in step 101, parameters for the nail penetration test are set, for example, parameters such as the preset voltage and the predetermined depth are set.

In step 102, it is determined that the nail penetration test is started.

In step 103, the penetrating nail 10 is controlled to move, and the voltage between the penetrating nail 10 and the positive electrode terminal of the battery cell 20 is detected during the movement.

In step 104, it is determined whether the voltage between the penetrating nail 10 and the positive electrode terminal exceeds a predetermined voltage during the movement of the penetrating nail 10.

If the voltage exceeds the predetermined voltage, step 105 is performed.

In step 105, a position where the penetrating nail 10 is located at the moment when the voltage between the penetrating nail 10 and the positive electrode terminal exceeds the predetermined voltage is determined as an initial penetration position of the penetrating nail 10, and the penetrating nail is controlled to continue moving with the initial penetration position as a starting point.

For example, a position where the penetrating nail 10 is located at the moment when the voltage between the penetrating nail 10 and the positive electrode terminal exceeds the predetermined voltage is determined as an initial penetration position of the penetrating nail 10, and the penetrating nail 10 is controlled to continue moving with the initial penetration position as a starting point.

In step 106, it is determined whether the penetrating nail 10 moves to a predetermined depth from the initial penetration position.

If the predetermined depth is reached, step 107 is performed. The predetermined depth is, for example, a penetration depth converted from the quantity of layers that are expected to be penetrated, or an expected penetration depth, such as 2 mm ± 0.5 mm.

In step 107, the penetrating nail 10 is controlled to stop.

After that, the state of the battery cell 20 may be observed. For example, the battery cell 20 is observed at an ambient test temperature for a period of time, for example, 1 h, to observe whether any incident such as fire or explosion occurs in the battery cell 20.

In step 108, it is determined that the nail penetration test is over.

The penetrating nail 10 is removed, the battery cell 20 is discharged to a predetermined end-of-discharge voltage, then the battery cell 20 is disassembled, and the quantity of short-circuit layers is recorded.

It may be learned that based on the above nail penetration test process, the initial penetration position of the penetrating nail 10 when the penetrating nail 10 touches or pierces the second electrode sheet 232 at the outermost layer can be accurately determined, and the penetrating nail 10 is controlled to continue moving based on the initial penetration position until the penetrating nail 10 is penetrated into the battery cell 20 to the predetermined depth. In this way, without complex modifications to the battery cell 20, the nail penetration test can be accurately and conveniently performed by using the relationship between the physical structure and the voltage of the battery cell 20, and test requirements for different penetration depths can be met while improving the test accuracy.

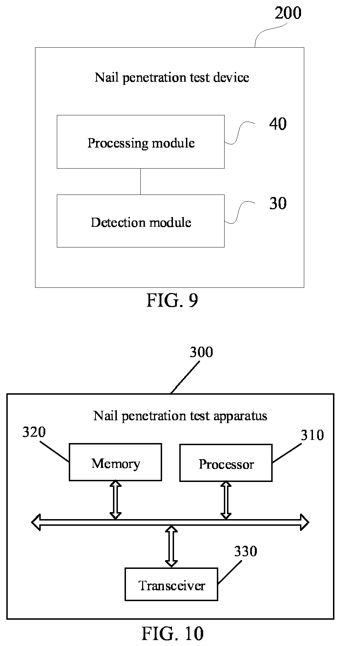

Further provided in the present application is a nail penetration test device 200. As shown in FIG. 9, the device 200 includes a processing module 40 and a detection module 30.

The processing module 40 is configured to control a penetrating nail 10 to move towards the direction where the penetrating nail is penetrated into a battery cell 20. The detection module 30 is configured to detect the voltage between the penetrating nail 10 and a first electrode terminal of the battery cell 20 during the movement of the penetrating nail 10. The processing module 40 is further configured to continue to control the penetrating nail 10 to penetrate into a predetermined depth when the voltage between the penetrating nail 10 and the first electrode terminal of the battery cell 20 exceeds a preset voltage.

The preset voltage is, for example, between 0.5 V and 1.5 V, such as 1 V.

In some embodiments, the battery cell 20 includes a first electrode sheet 231 and a second electrode sheet 232 that are disposed in an overlapping manner, an electrode sheet located at the outermost layer is the second electrode sheet 232, the first electrode terminal is an electrode terminal connected to the first electrode sheet 231, and the polarity of the first electrode sheet 231 is opposite to that of the second electrode sheet 232.

In some embodiments, the predetermined depth is determined based on the quantity of layers of electrode sheets that need to be penetrated in the nail penetration test.

In some embodiments, the predetermined depth is determined based on the quantity of layers of electrode sheets that need to be penetrated, the thickness of the first electrode sheet 231, and the thickness of the second electrode sheet 232.

In some embodiments, the predetermined depth is determined based on the quantity of layers, the thickness of the first electrode sheet 231, the thickness of the second electrode sheet 232, and the thickness of a separator 233 between the first electrode sheet 231 and the second electrode sheet 232 and/or a preset gap value.

In some embodiments, when the quantity of layers is 1, the predetermined depth is L₁, where C+S+D≤L₁≤A+C+S+D; and/or, when the quantity of layers is N, the predetermined depth is L_{N}, where (A+C+S+D)+(A+C+2S)*(N-2)+(C+2S)≤L_{N}≤(A+C+S+D)+(A+C+2S)*(N-1), and N is a positive integer greater than 1. A, C, S, and D are respectively the thickness of the first electrode sheet 231, the thickness of the second electrode sheet 232, the thickness of the separator 233, and the gap value.

In some embodiments, the processing module 40 is further configured to control the battery cell 20 to be charged to a predetermined SOC.

It should be understood that the device 200 is configured to perform the nail penetration test method 100. For specific details of the device 200, reference may be made to the above description of the method 100, and details are not described herein again for brevity.

Further provided in the present application is a nail penetration test apparatus. As shown in FIG. 10, the apparatus 300 includes a processor 310, where the processor 310 is configured to execute computer instructions stored in a memory 320 to enable the apparatus to implement the nail penetration test method 100 according to any one of the above embodiments. The apparatus 300 may be, for example, a host computer. Optionally, the apparatus 300 further includes a memory 320 configured to store computer instructions. The memory 320 may be a separate device independent of the processor 310, or may be integrated into the processor 310.

Optionally, as shown in FIG. 10, the detection device 300 may further include a transceiver 330, and the processor 310 may control the transceiver 330 to communicate with another device. For example, the transceiver may send information or data to another device, or receive information or data sent by another device.

It should be understood that the processor in the embodiments of the present application may be an integrated circuit chip with a signal processing capability. During implementation, the steps of the above method embodiments may be completed by an integrated logic circuit of hardware in the processor or instructions in the form of software. The processor may be a general-purpose processor, a digital signal processor (DSP), an application specific integrated circuit (ASIC), a field programmable gate array (FPGA), another programmable logic device, a discrete gate or transistor logic device, or a discrete hardware component. The methods, steps, and logic block diagrams disclosed in the embodiments of the present application may be implemented or executed. The general-purpose processor may be a microprocessor, or any conventional processor, etc. The steps of the method disclosed with reference to the embodiments of the present application may be directly performed by a hardware decoding processor, or may be performed using a combination of hardware and software modules in the decoding processor. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory and completes the steps of the method in combination with hardware of the processor.

It may be understood that the memory in the embodiments of the present application may be a volatile memory or a nonvolatile memory, or include both a volatile memory and a nonvolatile memory. The nonvolatile memory may be a read-only memory (ROM), a programmable ROM (PROM), an erasable PROM (EPROM), an electrically EPROM (EEPROM), or a flash memory. The volatile memory may be a random access memory (RAM), which serves as an external cache. By way of illustrative but not restrictive description, many forms of RAMs are available, for example, a static RAM (SRAM), a dynamic RAM (DRAM), a synchronous DRAM (SDRAM), a double data rate SDRAM (DDR SDRAM), an enhanced SDRAM (ESDRAM), a synchlink DRAM (SLDRAM), and a direct rambus RAM (DR RAM). It should be noted that the memories of the systems and methods described herein are intended to include, but are not limited to, these and any other suitable types of memories.

Further provided in the present application is a computer-readable storage medium configured to store a computer program that, when executed by a computing device, enables the computing device to implement the nail penetration test method 100 according to any one of the above embodiments. The computer-readable storage medium may be, for example, the memory 320.

It should be noted that, under the premise of no conflict, the embodiments described in the present application and/or the technical features in the embodiments may be arbitrarily combined with each other, and the technical solution obtained after the combination should also fall within the scope of protection of the present application.

In this embodiment of the present application, sequence numbers of the processes do not mean execution sequences. The execution sequences of the processes should be determined according to functions and internal logic of the processes, and should not be construed as any limitation on the implementation processes of the embodiments of the present application.

Those of ordinary skill in the art may realize that the units and algorithm steps of each example described in conjunction with the embodiments disclosed herein may be implemented in electronic hardware, or a combination of computer software and electronic hardware. Whether these functions are performed in hardware or software depends on the particular application and design constraints of the technical solution. Skilled artisans may use different methods to implement the described functions for each particular application, but such implementation should not be considered beyond the scope of the present application.

Those skilled in the art may clearly understand that, for the convenience and brevity of description, for the specific working processes of the systems, devices, and units described above, reference may be made to the corresponding processes in the above method embodiments, which will not be repeated herein.

In several embodiments provided in the present application, it should be understood that the disclosed systems, devices, and methods may be implemented in other ways. For example, the device embodiments described above are merely illustrative. For example, the division of the units is merely a logical function division, and there may be other division manners in actual implementation. For example, a plurality of units or assemblies may be combined or may be integrated into another system, or some features may be ignored or not performed. On the other hand, the mutual coupling or direct coupling or communication connection shown or discussed may be through some interfaces, and the indirect coupling or communication connection between the devices or units may be in an electrical, mechanical or other forms.

The units described as separate components may or may not be physically separated, and the components shown as units may or may not be physical units, that is, may be located in one place, or may be distributed over a plurality of network units. Some or all of the units may be selected according to actual requirements to achieve the purpose of the solution of this embodiment of the present application.

## Claims

1. A nail penetration test method, **characterized by** comprising:
controlling a penetrating nail to move towards the direction where the penetrating nail is penetrated into a battery cell; and
continuing controlling the penetrating nail to penetrate into a predetermined depth when the voltage between the penetrating nail and a first electrode terminal of the battery cell exceeds a preset voltage.

2. The method according to claim 1, wherein the battery cell comprises a first electrode sheet and a second electrode sheet that are disposed in an overlapping manner, an electrode sheet located at the outermost layer is the second electrode sheet, the first electrode terminal is an electrode terminal connected to the first electrode sheet, and the polarity of the first electrode sheet is opposite to that of the second electrode sheet.

3. The method according to claim 1 or 2, wherein the predetermined depth is determined based on the quantity of layers of electrode sheets that need to be penetrated in the nail penetration test.

4. The method according to claim 3, wherein the predetermined depth is determined based on the quantity of layers, the thickness of the first electrode sheet of the battery cell, and the thickness of the second electrode sheet of the battery cell.

5. The method according to claim 4, wherein the predetermined depth is determined based on the quantity of layers, the thickness of the first electrode sheet, the thickness of the second electrode sheet, and the thickness of a separator and/or a preset gap value between the first electrode sheet and the second electrode sheet.

6. The method according to claim 5, wherein
when the quantity of layers is 1, the predetermined depth is L₁, wherein C+S+D≤L₁≤A+C+S+D; and/or
when the quantity of layers is N, the predetermined depth is L_{N}, wherein (A+C+S+D)+(A+C+2S)*(N-2)+(C+2S)≤L_{N}≤(A+C+S+D)+(A+C+2S)*(N-1), and N is a positive integer greater than 1; and
A is the thickness of the first electrode sheet, C is the thickness of the second electrode sheet, S is the thickness of the separator, and D is the gap value.

7. The method according to any one of claims 1 to 6, wherein the preset voltage is greater than or equal to 0.5 V and less than or equal to 1.5 V.

8. The method according to claim 7, wherein the preset voltage is 1 V.

9. The method according to any one of claims 1 to 8, wherein the battery cell further comprises a shell, the shell is configured to accommodate the first electrode sheet and the second electrode sheet of the battery cell, and an avoidance hole is disposed at a position on the shell for the penetrating nail to penetrate.

10. The method according to any one of claims 1 to 9, further comprising:
controlling the battery cell to be charged to a predetermined state of charge SOC, and left to stand for predetermined duration.

11. A nail penetration test device, **characterized by** comprising:
a processing module, configured to control a penetrating nail to move towards the direction where the penetrating nail is penetrated into a battery cell; and
a detection module, configured to detect the voltage between the penetrating nail and a first electrode terminal of the battery cell during the movement of the penetrating nail; wherein
the processing module is further configured to continue controlling the penetrating nail to penetrate into a predetermined depth when the voltage between the penetrating nail and the first electrode terminal of the battery cell exceeds a preset voltage.

12. The device according to claim 11, wherein the battery cell comprises a first electrode sheet and a second electrode sheet that are disposed in an overlapping manner, an electrode sheet located at the outermost layer is the second electrode sheet, the first electrode terminal is an electrode terminal connected to the first electrode sheet, and the polarity of the first electrode sheet is opposite to that of the second electrode sheet.

13. The device according to claim 11 or 12, wherein the predetermined depth is determined based on the quantity of layers of electrode sheets that need to be penetrated in the nail penetration test.

14. The device according to claim 13, wherein the predetermined depth is determined based on the quantity of layers, the thickness of the first electrode sheet of the battery cell, and the thickness of the second electrode sheet of the battery cell.

15. The device according to claim 14, wherein the predetermined depth is determined based on the quantity of layers, the thickness of the first electrode sheet, the thickness of the second electrode sheet, and the thickness of a separator and/or a preset gap value between the first electrode sheet and the second electrode sheet.

16. The device according to claim 15, wherein
when the quantity of layers is 1, the predetermined depth is L₁, wherein C+S+D≤L₁≤A+C+S+D; and/or
when the quantity of layers is N, the predetermined depth is L_{N}, wherein (A+C+S+D)+(A+C+2S)*(N-2)+(C+2S)≤L_{N}≤(A+C+S+D)+(A+C+2S)*(N-1), and N is a positive integer greater than 1; and
A, C, S, and D are respectively the thickness of the first electrode sheet, the thickness of the second electrode sheet, the thickness of the separator, and the gap value.

17. The device according to any one of claims 11 to 16, wherein the preset voltage is greater than or equal to 0.5 V and less than or equal to 1.5 V.

18. The device according to claim 17, wherein the preset voltage is 1 V.

19. The device according to any one of claims 11 to 18, wherein the battery cell further comprises a shell, the shell is configured to accommodate the first electrode sheet and the second electrode sheet of the battery cell, and an avoidance hole is disposed at a position on the shell for the penetrating nail to penetrate.

20. The device according to any one of claims 11 to 19, wherein the processing module is further configured to control the battery cell to be charged to a predetermined state of charge SOC.

21. A nail penetration test apparatus, **characterized by** comprising a processor, wherein the processor is configured to execute computer instructions stored in a memory to enable the apparatus to implement the nail penetration test method according to any one of claims 1 to 10.

22. A computer-readable storage medium, **characterized in that** the computer-readable storage medium is configured to store a computer program that, when executed by a computing device, enables the computing device to implement the nail penetration test method according to any one of claims 1 to 10.
